# EUROPÄISCHE PATENTSCHRIFT

(11) **EP 1 413 108 B1**
(45) Veröffentlichungstag und Bekanntmachung des Hinweises auf die Patenterteilung: **02.01.2008**
(21) Anmeldenummer: 02727297.0
(22) Anmeldetag: 10.04.2002
(51) Int. Cl.: H04L 27/00

(54) **VERFAHREN ZUR VERMEIDUNG VON STÖRAUSSTRAHLUNGEN BEI AM-SENDERN FÜR DIGITALE ÜBERTRAGUNG**
METHOD FOR AVOIDING INTERFERENCE RADIATION OF AM TRANSMITTERS USED IN DIGITAL TRANSMISSION
PROCEDE POUR EVITER DES EMISSIONS PARASITES AVEC DES EMETTEURS A MODULATION D'AMPLITUDE DANS LE CADRE D'UNE TRANSMISSION NUMERIQUE

(30) Priorität: 27.06.2001 DE 10131849
(43) Veröffentlichungstag der Anmeldung: 28.04.2004
(73) Patentinhaber: Deutsche Telekom AG, 53113 Bonn (DE)
(72) Erfinder: RUDOLPH, Dietmar, 14163 Berlin (DE)
(86) Internationale Anmeldenummer: PCT/DE2002/001315
(87) Internationale Veröffentlichungsnummer: WO 2003/003683

(56) Entgegenhaltungen:
- EP-A- 1 011 192
- EP-A- 1 150 422
- US-A- 4 878 030
- US-B1- 6 191 653

## Beschreibung

Die Erfindung betrifft das Gebiet der Rundfunksender, die im Zuge der Digitalisierung von analoger Amplitudenmodulation (AM) auf digitale Modulation umgestellt werden.

Die bisher üblichen Sendertypen, nichtlineare AM-Sender mit RF-Eingang (Radio Frequency) und Audioeingang, sollen dabei weiterhin verwendet werden. Dies hat folgende Gründe:
- Die AM-Sender arbeiten intern im Schaltbetrieb und haben demzufolge bis zu einem Faktor 3 bessere Wirkungsgrade als lineare Sender, die sonst üblicherweise für digitale Übertragung, z.B. bei DAB (Digital Audio Broadcasting) und DVB (Digital Video Broadcasting), eingesetzt werden. Dadurch ergibt sich eine Einsparung an Betriebskosten.
- Die Broadcaster sind leichter zur Umstellung von analog auf digital zu überzeugen, wenn keine großen Investitionen im Vorfeld anfallen.

Die Digitalisierung des AM-Rundfunks wird als einzige Chance gesehen, diese Frequenzbereiche und die darin angewendete Technologie langfristig zu erhalten. Für die Umsetzung wurde das Konsortium "Digital Radio Mondiale" gegründet, siehe Rundfunktechnische Mitteilungen, Jahrgang 43, 1999, Heft 1, Seite 29-35.

Die Verwendung eines nichtlinearen AM-Senders für digitale Modulation erfordert eine spezielle Betriebsart des Senders. Die Erzeugung des modulierten digitalen Signals erfolgt mittels zweier, zueinander orthogonaler Teilsignale (I und Q). Das I-Signal ("In Phase") wird auf eine Kosinusschwingung mit der Frequenz Ft (Trägerfrequenz) moduliert. Das Q-Signal ("Quadratur") wird auf eine Sinusschwingung der gleichen Frequenz Ft moduliert. Die Summe beider modulierten Schwingungen ergibt das komplexe modulierte Datensignal (Kosinus 0 - 180 Grad, Sinus -90 - +90 Grad). Das modulierte I/Q-Signal wird durch Filter so geformt, dass es exakt die vorgeschriebene Kurvenform mit der gewünschten Bandbreite hat.

Für den nichtlinearen Betrieb muss das modulierte I/Q-Signal so umgewandelt werden, dass die beiden Signale Amplitudensignal (A-Signal) und phasenmoduliertes Trägersignal (RF-P) daraus entstehen, die geeignet sind, den AM-Sender richtig anzusteuern. Am Ausgang des AM-Senders ergibt sich hernach wiederum das modulierte I/Q-Signal mit größerer Leistung.

Das modulierte I/Q-Signal entspricht einer kartesischen Darstellung. Diese wird in eine polare Darstellung mit Amplitude und Phase überführt. Für die Ansteuerung des AM-Senders am Audioeingang wird dadurch das Amplitudensignal (A-Signal) gewonnen. Aus dem zunächst entstehenden Phasensignal (P-Signal) wird eine phasenmodulierte RF (RF-P-Signal) erzeugt. Vorteilhaft kann auch das RF-P-Signal ohne den Zwischenschritt über das P-Signal direkt gewonnen werden. Damit erhält man die für die Ansteuerung des AM-Senders notwendigen Signale:
- Amplitudensignal (A-Signal)
- Phasenmoduliertes RF-Signal (RF-P-Signal)

Das A-Signal wird in den Modulatoreingang (Audioeingang) des AM-Senders gegeben und das RF-P-Signal dient zur HF-mäßigen Ansteuerung des Senders. In der Senderendstufe werden die beiden Signale A & RF-P multiplikativ vereinigt und bilden das hochfrequente digitale Ausgangssignal.

Sowohl das A-Signal als auch das RF-P-Signal erhalten aufgrund des erforderlichen Aufbereitungsprozesses weit größere Bandbreiten, als das digitale Signal zunächst hatte und auch am Ausgang des Senders wieder haben soll.

Die erhöhten Bandbreiten (3 - 5 mal der Bandbreite im AM Mode des Senders) können häufig von den älteren Modulatoren nicht bereitgestellt werden, da diese dafür nicht ausgelegt wurden. Wird nur die eingeschränkte Bandbreite verwendet, die "ältere" Sender im Modulatorteil zur Verfügung haben, so führt das zu erheblichen Außerbandabstrahlungen. Diese haben die Eigenschaft, dass sie im Spektrum nur eine sehr geringe Steigung aufweisen und somit recht viele Nachbarkanäle stören.

Die Bandbegrenzung im Amplitudenzweig (A-Zweig) und auch im RF-Zweig führt also zu Störaussendungen, deren Schulterabstand bezogen auf das Spektrum des Nutzkanals die Forderungen der ITU nicht oder nur sehr unzureichend erfüllt.

Die Erfindung stellt sich die Aufgabe, die aufgrund der Bandbegrenzung im Amplitudenzweig und auch im RF-Zweig des AM-Senders auftretenden nichtlinearen Verzerrungen zu beheben, damit bei der Abstrahlung des digitalen Signals die Grenzwerte der ITU eingehalten werden.

Durch die Bandbegrenzung im A-Zweig und auch RF-Zweig werden im einzelnen folgende Übertragungsfehler verursacht:
- Amplitudengang im A-Zweig ist nicht konstant, sondern nimmt mit steigender Frequenz ab
- Phasengang im A-Zweig ist nicht linear und damit die Laufzeit nicht konstant
- Amplituden- und Laufzeitgang des RF-Zweiges sind nicht konstant
- Signallaufzeiten des A-Zweiges und des RF-Zweiges sind unterschiedlich (Delay).

Die unterschiedlichen Signallaufzeiten zwischen Amplituden- und RF-Zweig müssen im digitalen Modulator bis auf Werte kleiner 1 Mikrosekunde genau abgeglichen werden. Der Abgleich funktioniert aber nur dann, wenn die Laufzeiten sowohl im Amplitudenzweig als auch im RF-Zweig über der Frequenz konstant sind. Die Bandbegrenzung in beiden Zweigen verursacht aber mit der Abnahme des Amplitudengangs bei steigender Frequenz auch eine damit verkoppelte Nichtlinearität der Phase bzw. damit verbundene nichtkonstante Laufzeiten.

Da im RF-Zweig die Bandbreite durch die Grenzfrequenzen der Schwingkreise speziell der Treiberstufe festgelegt ist, kann durch geeignete Wahl der Güte der Schwingkreise eine so große Bandbreite eingestellt werden, dass die dann noch resultierende Außerbandabstrahlung gegenüber derjenigen, die durch andere Einflüsse entsteht, vernachlässigbar wird.

Für den Amplitudenzweig soll die Bandbegrenzung und die daraus resultierende Verzerrung für Amplituden- und Laufzeitgang dadurch behoben werden, dass für das Amplitudensignal eine Vorentzerrung mit inverser Übertragungsfunktion angewendet wird, um dadurch eine optimale Kompensation des nicht konstanten Amplituden- und Laufzeitganges zu erreichen.

Der inverse Verlauf der Übertragungsfunktion wird auf den Frequenzbereich von 0 - 20 KHz begrenzt. Dieser Wert ist dadurch vorgegeben, dass im A-Zweig eine Bandbreite von ca. 3 - 5 mal der NF-Bandbreite bzw. der Bandbreite des digitalen I/Q-Signals von 4,5 KHz (LW und MW) bzw. 5 KHz (KW) erforderlich ist und durch die Begrenzung auf diesen Bereich keine Instabilität entstehen kann. Im Falle einer senderseitigen Bündelung von Übertragungskanälen (zwei bis vier benachbarte Kanäle) erhöhen sich die genannten Zahlenwerte für die Bandbreite gemäß dem Faktor der Bündelung.

Die Anwendung dieses Verfahrens erfordert, dass die Kurvenverläufe für Amplituden- und Laufzeitgang des A-Zweiges messtechnisch erfasst und gespeichert vorliegen. Durch numerische Interpolation werden dann die mathematischen Werte der Übertragungsfunktion für Betrag und Phase bestimmt, wobei der Phasenverlauf durch Integration über den gemessenen Laufzeitverlauf ermittelt wird. Die Impulsantwort zu den gemessenen Verläufen von Amplitude und Phase wird durch eine inverse Fouriertransformation bestimmt. Damit liefert die Impulsantwort die Koeffizienten für das Filter zur Vorentzerrung des Amplitudensignals, so dass eine Kompensation der Nichtlinearitäten im A-Zweig erreicht wird.

Als Netzwerk für die Vorentzerrung kann ein Filter mit FIR-Struktur (finite impulse response) verwendet werden, bei dem hinter jeder Stufe der Kette von Verzögerungsgliedern ein Abgriff des Signals möglich ist, so dass die abgegriffenen Signale gemäß der gewünschten Impulsantwort gewichtet und aufaddiert werden können.

Das Netzwerk mit inversen Amplituden- und Phasen- bzw. Laufzeitverlauf wird in Serie vor den Amplitudenzweig des Senders geschaltet.

Da die Antennen-Anpassung des Senders auf den Amplituden- und Phasen- bzw. Laufzeitgang des A-Zweiges zurückwirkt, ergeben sich je nach Anpassungsverhältnissen unterschiedliche Verläufe. Es liegt also nahe, für übliche Anpassungsverhältnisse diese Verläufe zu messen und die Ergebnisse zu speichern. Damit wird es möglich, z.B. bei witterungsbedingten Impedanz-Schwankungen der Antennen-Anpassung die passenden Verläufe für die Kompensation auszuwählen. Das Auswahlkriterium hierzu kann die sowieso im Sender vorhandene Messeinrichtung für die Antennen-Anpassung bereitstellen, die ggf. hierfür zu modifizieren und anzupassen ist. Damit ist die Kompensation ideal an die praktischen Bedingungen des Senderbetriebes angepasst. Es ist auch sehr einfach möglich, durch Korrekturen an den eingespeicherten Kurvenverläufen ein Optimum beim erreichten Schulterabstand zu kontrollieren.

Die Kompensation des nicht konstanten Amplituden- und Laufzeitganges durch eine Vorentzerrung mit inverser Übertragungsfunktion kann auch für den RF-Zweig angewendet werden.

Soweit Amplitudenzweig und RF-Zweig über eine konstante Laufzeit verfügen, kann zum Ausgleich der Laufzeitdifferenz zwischen beiden Zweigen die einfache Methode der Verzögerung des Signals mit der kleineren Laufzeit angewendet werden.

## Patentansprüche

1. Verfahren zur Vermeidung von Störausstrahlungen bei AM-Sendern für digitale Übertragung, bei denen die digitale Modulation für die Ansteuerung der AM-Sender umgesetzt wird in ein Amplitudensignal und ein phasenmoduliertes RF-Signal,
**dadurch gekennzeichnet,**
**dass** im Amplitudenzweig die nichtlinearen Verzerrungen **dadurch** kompensiert werden, dass eine Vorentzerrung mit inversem Verlauf für Amplituden- und Laufzeitgang angewendet wird,
**dass** dafür Amplituden- und Laufzeitgang im Amplitudenzweig gemessen und gespeichert werden,
**dass** aus den gemessenen Verläufen für Amplituden- und Laufzeitgang durch inverse Fouriertransformation die inverse Übertragungsfunktion ermittelt wird,
**dass** ein Entzerremetzwerk für die inverse Übertragungsfunktion dimensioniert wird,
**dass** das Entzerremetzwerk in Serie vor den Amplitudenzweig geschaltet wird,
**dass** im RF-Zweig die Bandbreite der Schwingkreise durch geeignete Wahl der Güte so eingestellt wird, dass ein linearer Verlauf für Amplituden- und Laufzeitgang erreicht wird, und
**dass** die Laufzeitdifferenz zwischen Amplitudenzweig und RF-Zweig im digitalen Modulator durch Verzögerung des Signals mit der kleineren Laufzeit ausgeglichen wird.

2. Verfahren nach Anspruch 1, **dadurch gekennzeichnet, dass** die inverse Übertragungsfunktion für das Entzerrernetzwerk auf den Frequenzbereich von 3 - 5 mal der Bandbreite des digitalen I/Q-Signals begrenzt wird, um Instabilität und Übersteuerung des Senders zu vermeiden.

3. Verfahren nach Anspruch 1, **dadurch gekennzeichnet, dass** Amplituden- und Laufzeitgang des Amplitudenzweiges bei unterschiedlichen Bedingungen für die zurückwirkende Antennenanpassung gemessen und gespeichert werden, damit bei witterungsbedingten Impedanzschwankungen die Vorentzerrung optimal angepasst werden kann.

4. Verfahren zur Vermeidung von Störausstrahlungen bei AM-Sendern für digitale Übertragung, bei denen die digitale Modulation für die Ansteuerung der AM-Sender umgesetzt wird in ein Amplitudensignal und ein phasenmoduliertes RF-Signal,
**dadurch gekennzeichnet, dass** auch für den RF-Zweig eine Kompensation der nichtlinearen Verzerrungen im Amplituden- und Laufzeitgang durch eine Vorentzerrung mit inverser Übertragungsfunktion angewendet wird.

## Claims

1. Method for avoiding radiated interference in AM transmitters for digital transmission, in which the digital modulation for controlling the AM transmitters is converted into an amplitude signal and a phase-modulated RF signal,
**characterized in that**
in the amplitude branch, the non-linear distortions are compensated **in that** a pre-equalization with inverse shape is applied for the amplitude response and the propagation delay characteristic,
**in that**, to this end, the amplitude response and the propagation delay characteristic in the amplitude branch are measured and stored,
**in that** the inverse transfer function is determined from the measured shapes of the amplitude response and the propagation delay characteristic by an inverse Fourier transform,
**in that** an equalizing network is dimensioned for the inverse transfer function,
**in that** the equalizing network is connected in series ahead of the amplitude branch,
**in that** the bandwidth of the resonant circuits is adjusted in the RF branch, through suitable selection of the quality factor, in such a manner that a linear shape is achieved for the amplitude response and the propagation delay characteristic, and
**in that** the propagation delay difference between the amplitude branch and the RF branch is compensated for in the digital modulator by delaying the signal having the smaller propagation delay.

2. Method according to claim 1, **characterized in that** the inverse transfer function for the equalizing network is limited to the frequency range of 3-5 times the bandwidth of the digital I/Q signal to avoid instability and overdriving of the transmitter.

3. Method according to claim 1, **characterized in that** the amplitude response and propagation delay characteristic of the amplitude branch are measured and stored under different conditions for reactive antenna matching so that the pre-equalization can be optimally adapted in the case of weather-related variations in impedance.

4. Method for avoiding radiated interference in AM transmitters for digital transmission, in which the digital modulation for controlling the AM transmitters is converted into an amplitude signal and a phase-modulated RF signal, **characterized in that** a compensation of the non-linear distortions in the amplitude response and propagation delay characteristic by a pre-equalization with an inverse transfer function is applied to the RF branch as well.

## Revendications

1. Procédé destiné à éviter les émissions parasites sur les émetteurs AM dans la transmission numérique, sur lesquels la modulation numérique de commande des émetteurs AM génère un signal d'amplitude et un signal de fréquence radio modulé en phase,
**caractérisé**
**en ce que**, dans la branche d'amplitude, les distorsions non linéaires sont compensées par application d'une pré-égalisation à allure inverse de la réponse en amplitude et en temps de propagation,
**en ce que**, pour ce faire, on mesure et on enregistre la réponse en amplitude et en temps de propagation dans la branche d'amplitude,
**en ce qu'**on détermine la fonction de transmission inverse par transformation de Fourier inverse à partir des allures obtenues pour la réponse en amplitude et en temps de propagation,
**en ce qu'**on dimensionne un réseau correcteur de la fonction de transmission inverse,
**en ce que** le réseau correcteur est monté en série en amont de la branche d' amplitude,
**en ce que**, dans la branche de fréquence radio, on règle la largeur de bande des circuits oscillateurs moyennant un choix approprié de la qualité de manière à obtenir une allure linéaire pour la réponse en amplitude et en temps de propagation, et
**en ce qu'**on compense la différence de temps de propagation entre la branche d'amplitude et la branche de fréquence radio dans le modulateur numérique par retard du signal présentant le plus petit temps de propagation.

2. Procédé selon la revendication 1, **caractérisé en ce que** la fonction de transmission inverse du réseau correcteur est limité au domaine de fréquence de 3 à 5 fois la largeur de bande du signal numérique I/Q afin d'éviter une instabilité et une saturation de l'émetteur.

3. Procédé selon la revendication 1, **caractérisé en ce qu'**on mesure et **en ce qu'**on enregistre la réponse en amplitude et en temps de propagation dans des conditions différentes pour l'adaptation d'antenne rétroactive afin d'adapter de manière optimale la pré-égalisation en cas de variations d'impédance dues aux intempéries.

4. Procédé destiné à éviter les émissions parasites sur les émetteurs AM pour la transmission numérique sur lesquels la modulation numérique de commande des émetteurs AM génère un signal d'amplitude et un signal de fréquence radio modulé en phase, **caractérisé en ce qu'**on applique également à la branche de fréquence radio une compensation des distorsions non linéaires de la réponse en amplitude et en temps de propagation par pré-égalisation à fonction de transmission inverse.
